# EUROPEAN PATENT SPECIFICATION

(11) **EP 2 053 144 B1**
(45) Date of publication and mention of the grant of the patent: **06.05.2015**
(21) Application number: 07791541.1
(22) Date of filing: 30.07.2007
(51) Int. Cl.: C23C 28/04, C21D 1/18, C23C 8/32, C23C 8/38, C23C 8/56, C23C 8/80, C23C 14/32, C23C 14/06, C21D 1/56, C23C 14/58, C23C 16/56, C23C 16/34, C23C 8/50

(54) **METHOD FOR PRODUCING QUENCHING OF STEEL MEMBER, QUENCHED STEEL MEMBER, AND USE OF A SURFACE PROTECTING AGENT IN A PROCESS FOR PRODUCING QUENCHED STEEL MEMBER**
VERFAHREN ZUR HERSTELLUNG EINES ABGESCHRECKTEN STAHLBAUELEMENTS, ABGESCHRECKTES BAUELEMENT, UND VERWENDUNG EINES MITTELS ZUM SCHUTZEN DER OBERFLÄCHE IN EINEM VERFAHREN ZUM HERSTELLEN EINES ABGESCHREKTEN STAHLBAUELEMENTS
PROCÉDÉ DE PRÉPARATION D'UNE PIÈCE EN ACIER TREMPÉE, PIÈCE EN ACIER TREMPÉE, ET UTILISATION D'UN AGENT DE PROTECTION DE SURFACE DANS UN PROCÉDÉ DE PRÉPARATION D'UN PIÈCE D'ACIER TREMPÉE

(30) Priority: 09.08.2006 JP 2006216577
(43) Date of publication of application: 29.04.2009
(73) Proprietor: NIHON PARKERIZING CO., LTD., Chuo-ku, Tokyo 103-0027 (JP)
(72) Inventor: BEPPU, Masaaki, Tokyo 103-0027 (JP); SAKUTA, Hidehisa, Tokyo 103-0027 (JP); MORI, Kazuhiko, Tokyo 103-0027 (JP)
(74) Representative: Hoffmann Eitle
(86) International application number: PCT/JP2007/064847
(87) International publication number: WO 2008/018308

(56) References cited:
- EP-A2- 0 229 325
- JP-A- 6 101 067
- JP-A- 01 031 984
- JP-A- 11 269 631
- JP-A- 58 096 815
- JP-A- 58 096 815
- US-B1- 6 258 141

## Description

### TECHNICAL FIELD

The present invention relates to techniques for surface hardening treatment of mechanical structural parts that are excellent in mechanical strengths such as contact pressure strength, abrasion resistance and bending fatigue strength.

### BACKGROUND ART

In order to enhance mechanical strengths, mechanical structural parts made of cast iron and/or steel are subjected to surface hardening treatments such as nitriding treatment, nitrocarburizing treatment, carburizing/quenching and induction quenching. Among them, nitride layers formed on the outermost surface by nitriding treatment are known for their excellent slide resistance, high abrasion resistance and high seizure resistance. Conventional nitriding or nitrocarburizing treatments are, however, shallow in depth of hardened layers in comparison with carburizing/quenching and induction quenching and leave room for improvement in contact pressure strength, fatigue strength and so on. As such, composite hardening treatments have recently been developed in which induction quenching is carried out after a nitriding or nitrocarburizing treatment, utilizing characteristics of nitrogen, to increase hardening depth, contact pressure strength and fatigue strength.

Such composite treatments are, however, expected to improve contact pressure strength and fatigue strength with utilizing characteristics of quenched textures in nitrogen diffusion layers obtained by nitriding treatments, namely, temper softening resistance and crack resistance in Patent References 1 to 4 for example and no utilization of nitride layers (compound layers) formed by nitriding treatments is found. Rather, in the publications mentioned above, discussion is made on induction treatment conditions for positively decomposing and dissipating nitride layers. In other words, for induction quenching after nitriding treatments, the quenching temperature needs to be at least at or higher than the Ac1 transformation temperature at which austenite is composed and is usually selected from the range of temperatures from 750 to 1050°C. Nitride layers formed at a nitriding temperature of 570°C is a combination of iron and nitrogen and, upon reheated at or higher than 650°C, oxidized to be decomposed so that the nitrogen of the nitride layers may be released as a nitrogen gas at the outermost surface and diffused on the inside, resulting in dissipation of the nitride layers. This has previously been reported (Nonpatent Reference 1).

Techniques for addressing the problem in which nitride layers are damaged and/or dissipated by high temperature heating caused by induction quenching nitride layers just as formed over the surface by nitriding treatments include a process in which a gas nitriding/ion nitriding inhibitor, carburizing inhibitor or oxidation inhibitor based on silicon oxide is coated at a thickness of 1 to 3 mm over the surface after a nitriding treatment, before carrying out quenching as disclosed in Patent Reference 5.

According to this process, however, it was difficult to obtain desired hardness of fine martensite, although oxidization may be inhibited while heating, because a film thickness of 1 mm or more is needed and thermal conductivity is low so that the cooling rate may be insufficient during quenching. Also, such a surface film has high abrasion resistance and, therefore, must be removed after quenching, resulting in an insufficient productivity.
Patent Reference 1: Japanese Patent No. 3193320
Patent Reference 2: Japanese Patent No. 3327386
Patent Reference 3: Japanese Patent No. 3145517
Patent Reference 4: Japanese Unexamined Patent Publication No. 1995-90364
Patent Reference 5: Japanese Unexamined Patent Publication No. 1983-96815
Nonpatent Reference 1: "Heat Treatment," Vol. 16, No. 4, p206, 1976

### DISCLOSURE OF THE INVENTION

### PROBLEMS TO BE SOLVED BY THE INVENTION

It is therefore the object of the present invention to solve such problems of the prior art and to prevent damages to and decomposition of hard nitride layers at the time of quenching and to further enhance the hardness and/or mechanical strengths to obtain contact pressure strength and fatigue strength as well as to obtain good slidability without removing the protective layers by combining the nitride layers with ceramics having a certain composition for reinforcement without lowering the cooling rate during quenching.

### MEANS FOR SOLVING THE PROBLEMS

The present inventors have conducted keen experiment and examination, in a process for producing quenched steel members by contacting a surface with a surface protective agent before quenching steel members having a hard nitride layer formed on the surface, on compositions of surface protective agents for contacting a steel material having a hard nitride layer over its surface in a process for producing quenched steel members that are capable of protecting nitride layers during quenching with the use of a film thickness of several µm or less (within the range of 1 to 2000 mg/m² in total in terms of the metals Ti, Zr, Hf, V, Nb, Ta, Cr, W, Mo and Al) with no problems in the cooling rate during quenching and no decrease in slidability without removing protective layers after quenching.

As a result, the inventors have found that a surface protective agent for contacting a steel material having a hard nitride layer over its surface in a process for producing quenched steel members comprising a ceramic precursor containing at least one metal selected from the group consisting of Ti, Zr, Hf, V, Nb, Ta, Cr, W, Mo and Al within the range of 1 to 2000 mg/m² in total in terms of such metals exhibits good nitride protecting effects as a thin film coating having a thickness of several µm or less which is heretofore unknown and exhibits good slidability without removing the protective film after a heat treatment and that the nitride protecting effects can further be improved by incorporating one member selected among Ca, Mg, Y, Sc and Ba into the surface protective agent.

Also, as a result of analyzing the cross sectional compositions of coated films after quenching on the basis of EPMA or the like, the inventors have assumed that these films exist as the top layer of the nitride film and are partly combined or reacted with the nitride to rigidly attach thereto to enhance the protective effects and slidability, to accomplish the present invention.

In other words, a first invention according to the present invention is a quenched steel member having a hard nitride layer formed on the surface of a steel material, which further comprises an inorganic compound layer containing at least one metal oxide selected from the group consisting of Ti, Zr, Hf, V, Nb, Ta, Cr, W, Mo and Al within the range of 1 to 2000 mg/m² in total in terms of such metals formed as the top layer thereof. A second invention is the first invention, wherein the inorganic compound layer containing the metal oxide further contains at least one member selected among Ca, Mg, Y, Sc and Ba. A third invention is the first invention or the second invention, wherein the hard nitride layer is at least one nitride selected among Fe, Ti, Zr, Mo, W, Cr, B and Si. A fourth invention is any one of the first to third inventions, wherein the steel member is a machine structural part to be used in regions with a high contact pressure.

A process for producing a quenched steel member according to as defined in any of the first to fourth inventions above comprises contacting a steel material having a hard nitride layer over its surface with a ceramic precursor-containing liquid containing at least one element selected from the group consisting of Ti, Zr, Hf, V, Nb, Ta, Cr, W, Mo and Al (for example, a ceramic precursor-containing solution containing the element in at least one state selected among oxide, hydrated oxide, ion and complex ion) before carrying out a quenching treatment, wherein the quenching treatment is preferably induction quenching and the ceramic precursor-containing liquid (the solution, for example) preferably further contains at least one element selected among Ca, Mg, Y, Sc and Ba (for example, containing the element in at least one state selected among oxide, hydrated oxide, ion and complex ion).

According to the present invention, use of a surface protective agent for contacting a steel material having a hard nitride layer over its surface in a process for producing a quenched steel member as defined in any of the first to fourth inventions above is provided, wherein a ceramic precursor-containing liquid containing at least one element selected from the group consisting of Ti, Zr, Hf, V, Nb, Ta, Cr, W, Mo and Al (for example, a ceramic precursor-containing solution containing the element in at least one state selected among oxide, hydrated oxide, ion and complex ion) and the ceramic precursor-containing liquid (the solution, for example) more preferably further contains at least one element selected among Ca, Mg, Y, Sc and Ba (for example, containing the element in at least one state selected among oxide, hydrated oxide, ion and complex ion). In addition to surface protective agents for quenching which may be used as received, those of a concentrated type which are diluted at the time of use and/or those of a dry type to which a solvent is added may be included in the concept of "surface protective agents for quenching" (hereinafter illustrated are, however, those which may be used as received). The invention is as set forth in the claims.

### EFFECT OF THE INVENTION

According to the quenched steel member, the process for producing a quenched steel member, and the use of a surface protective agent in contacting a steel material having a hard nitride layer over its surface in the present invention, since it is possible to prevent damages to and decomposition of hard nitride layers as unconventionally thin films at the time of quenching, quenching is enabled without lowering the cooling rate during quenching to thereby obtain high hardness and/or mechanical strengths. Also, since good slidability can be obtained without removing the protective layers, mass productivity and practicability can be enhanced in comparison with the prior art.

### BRIEF DESCRIPTION OF THE DRAWINGS

### BEST MODE FOR CARRYING OUT THE INVENTION

To begin with, each element of quenched steel members according to the present invention will be described in detail. First, steel materials to which the present invention is applied are not particularly limited, examples of which include carbon steel, low alloy steel, high alloy steel and cast iron. Particularly preferred materials include high carbon steel and low alloy steel.

Hard nitride layers on the surface of steel materials according to the present invention are not particularly limited as long as they are nitride layers formed by surface treating steel (by nitrogen diffusion treatment, CVD, PVD and the like) and are preferably at least one nitride layer selected among Fe, Ti, Zr, Mo, W, Cr, B and Si, with Fe being most preferable in view of mass productivity. Preferred processes for forming hard nitride layers of Fe include salt-bath nitriding treatments such as Isonite treatment (Tuftride treatment) and Palsonite treatment as well as nitriding treatments such as gas nitrocarburizing treatment, ion nitriding treatment and plasma nitriding treatment. Hard nitride layers of elements other than Fe may preferably be formed by processes such as PVD such as plasma CVD, sputtering and ion plating.

Inorganic compound layers according to the present invention exist over the hard nitride layers on the surface of steel materials and contain, as principal components, at least one metal oxide selected from the group consisting of Ti, Zr, Hf, V, Nb, Ta, Cr, W, Mo and Al within the range of 1 to 2000 mg/m² in total in terms of such metals and, preferably, further contain, as optional components, at least one member selected from Ca, Mg, Ba, Y and Sc. The former principal components are excellent in oxidization resistance and nitride forming performance and the preferred optional components are expected to provide improvement in physical properties and stability of crystals.

The inorganic compound layers containing at least one metal oxide selected from the group consisting of Ti, Zr, Hf, V, Nb, Ta, Cr, W, Mo and Al preferably further contain nitrides of such metals. Improvement in hardenability and slidability may be expected by the inorganic compound layers including these metal nitrides. When quenching is carried out with a ceramic precursor containing such metals applied over the hard nitride layers, since nitrides are stable with respect to those metals, part of the metals will react with nitrogen from the hard nitride layers during quenching to form nitrides. In such a case, therefore, the inorganic compound layers containing the metal oxides will essentially contain nitrides.

The inorganic compound layers contain at least one essential metal selected from the group of the mentioned metals in an amount of 1 to 2000 mg/m² in total in terms of such metals. If the total amount in terms of the metals is less than 1 mg/m², protective effects on the nitride layers will be insufficient, while over 2000 mg/m², slidability and adherence will disadvantageously decrease. Such values used herein represent the amounts of the metals in inorganic compound layers after formation of such layers and the values are identical to the amounts of metals in the ceramic precursor liquid applied to the surface of steel before quenching. The amounts of the optional metals are preferably about 20% or less based on the essential metals.

Next, applications of the quenched steel members according to the present invention will be described. The quenched steel members according to the present invention are preferably used in high pressure regions wherein contact pressures are preferably in the range of 0.5 MPa to 3.5 Mpa. Shape of the steel members and parts and pieces which the steel members compose are not particularly limited, examples of which include axes, gear, pistons, shafts and cams.

Next, a process for producing a quenched steel member according to the present invention will be described. The process comprises, as essential steps, a step of applying a ceramic precursor-containing liquid to a steel material having a hard nitride layer over its surface and a step of quenching the steel material having the applied liquid. The processes may also comprise a drying step or the like for removing a solvent of the ceramic precursor liquid applied over the surface of the steel members. In such a case, the drying step may preferably be carried out before quenching, irrespective of the method, such as air drying or heat drying.

First to describe the step of application, before quenching, the steel material having a hard nitride layer (for example, a layer containing iron nitride) over its surface is contacted with the ceramic precursor-containing solution containing at least one element selected from the group consisting of Ti, Zr, Hf, V, Nb, Ta, Cr, W, Mo and Al within the range of 1 to 2000 mg/m² in total in terms of such metals in the liquid applied to the surface of the steel before quenching in at least one state selected among oxide, hydrated oxide, ion and complex ion. In addition to such elements, the solution may more preferably further contain an element selected among Ca, Mg, Y, Sc and Ba. Methods for contacting are not particularly limited, examples of which include spraying, dipping, brushing, flow coating, roll coating and electrolytic deposition.

Next to describe the step of quenching, the step is not particularly limited, examples of which include salt-bath quenching, flame quenching and induction quenching, with induction quenching being most preferable. As to conditions for quenching, for low alloy steel materials for example, quenching is generally preset at 900 to 930°C, 50 to 60°C higher than the austenizing temperatures of the materials. According to the present invention, however, since a nitriding treatment is previously carried out, quenching is more preferably preset at 800 to 850°C for induction quenching capable of rapid heating.

The metals contained in the ceramic precursor applied to the surface of the steel members undergo an oxide formation process, when the metals do not exist as oxides, to be vitrified to be ceramicized. Since the metals are more stable as nitrides than as oxides as described above, the metals react with nitrogen from the nitride layers during the step of quenching to form nitrides of such metals as well.

Next, a surface protective agent for contacting a steel material having a hard nitride layer over its surface according to the present invention is a ceramic precursor-containing solution containing at least one element selected from the group consisting of Ti, Zr, Hf, V, Nb, Ta, Cr, W, Mo and Al in at least one state selected among oxide, hydrated oxide, ion and complex ion. Among these metals, oxides, hydrated oxides, ions or complex ions of Ti, Zr, Hf, V, Nb, Ta, W, Mo and Al are preferred as principal components, to which oxides, hydrated oxides, ions or complex ions of Ca, Mg, Ba, Y and Sc are more preferably added as supplements. As a solvent for the ceramic precursor-containing liquid (for example, solution) water is preferably the principal solvent in view of safety and the solvent is more preferably from neutral to alkaline for preventing corrosion of steel members. Solids concentrations of the solution are not particularly limited and are preferably from 0.1 to 10 wt%.

A process for producing protective agents for use in contacting a steel material having a hard nitride layer over its surface in a process for producing quenched steel members (process for preparing ceramic precursor solutions) may preferably use, as metal compound materials, metal salts of such metals, such as nitrates, acetates and oxalates and/or metal alkoxides of such metals. These metal compound materials as received may be diluted in a solvent for use or may be used as dispersed sols of oxides and/or hydrated oxides by hydrolysis, heating crystallization or the like. Commercially available sols of these metal oxides may also be used. The surface protective agents for use in contacting a steel material having a hard nitride layer over its surface in a process for producing quenched steel members may preferably contain dispersants and/or stabilizers for sols, wettability enhancing agents, thickening agents and other organic and inorganic additives as supplements.

### EXAMPLES

Embodiments of the present invention will be illustrated with reference to examples, but the scope of the present invention will not be limited to such examples.

### Example 1

An SCM 440 tempered material 8 mm in diameter and 12 mm in length was used as a substrate, whose surface was degreased, and was then nitrocarburized in a fused salt bath at 570°C for two hours (Isonite treatment: Nihon Parkerizing Co., Ltd.) and oil cooled to form a compound layer comprising iron nitride 12 µm in thickness over the surface of the steel material.

To the steel material having the iron nitride layer formed over the surface, a neutral dispersed sol of 4% titanium oxide in water (Paltitan 5603: anatase + amorphous sol, Nihon Parkerizing Co., Ltd.) was also dip coated, removing excess liquid, and was then dried at 180°C. Ti deposit as measured using a fluorescent X-ray analyzer was 150 mg/m².

The steel material having the iron nitride layer formed on which the inorganic compound layer containing titanium oxide was formed in this manner was also heated at a rate of 150°C/sec using an induction quenching device and applied with a high frequency wave at 850°C for three seconds, immediately followed by water cooling for quenching.

### Example 2

A tempered material (SCM 440) 20 mm in diameter and 40 mm in length was used as a substrate, whose surface was degreased, and was then nitrocarburized in a fused salt bath at 570°C for two hours (Isonite treatment: Nihon Parkerizing Co., Ltd.) to form a compound layer comprising iron nitride 10 µm in thickness over the surface of the steel material.

To the steel material having the iron nitride layer formed over the surface in this manner, a coating solution containing 8% ammonium zirconium carbonate (Daiichi Kigenso Kagaku Kogyo Co., Ltd.) and yttrium oxide was also brush coated and was then dried at 150°C. Deposits of Zr and Y as measured using a fluorescent X-ray analyzer were 850 mg/m² and 50 mg/m² respectively.

The steel material having the iron nitride layer formed on which the inorganic compound layer comprising oxides containing zirconium and yttrium was formed in this manner was also applied with a high frequency wave at 800°C for five seconds using the induction quenching device of Example 1, immediately followed by water cooling for quenching.

### Example 3

An SCM 440 tempered material 8 mm in diameter and 12 mm in length was used as a substrate, whose surface was degreased, and was then nitrocarburized in a fused salt bath at 570°C for two hours (Isonite treatment: Nihon Parkerizing Co., Ltd.) to form an iron nitride layer 12 µm in thickness over the surface of the steel material.

To the steel material having the iron nitride layer formed over the surface in this manner, a sol of 10% alumina (Aluminasol 200, Nissan Chemical Industries, Ltd.) was brush coated and was then dried. Al deposit as measured using a fluorescent X-ray analyzer was 1300 mg/m².

The steel material having the iron nitride layer formed on which the inorganic compound layer containing aluminum oxide was formed in this manner was also applied with a high frequency wave at 850°C for three seconds using the same induction quenching device of Example 1, immediately followed by water cooling for quenching.

### Example 4

An SCM 440 tempered material 8 mm in diameter and 12 mm in length was used as a substrate, whose surface was degreased, and was then nitrocarburized in a fused salt bath at 570°C for two hours (Isonite treatment: Nihon Parkerizing Co., Ltd.) to form an iron nitride layer 12 µm in thickness over the surface of the steel material.

To the steel material having the iron nitride layer formed over the surface in this manner, a coating solution containing 3% ammonium molybdate and 2% ammonium tungstate was also dip coated and was then dried. Deposits of Mo and W as measured using a fluorescent X-ray analyzer were 150 mg/m² and 100 mg/m² respectively.

The steel material having the iron nitride layer formed on which the inorganic compound layer comprising oxides containing tungsten and molybdenum was formed in this manner was also applied with a high frequency wave at 800°C for five seconds using the same induction quenching device of Example 1, immediately followed by water cooling for quenching.

### Example 5

An tempered material (SCM 440) 20 mm in diameter and 40 mm in length was used as a substrate, whose surface was degreased, and was then nitrocarburized in a fused salt bath at 570°C for two hours (Isonite treatment: Nihon Parkerizing Co., Ltd.) to form an iron nitride layer 10 µm in thickness over the surface of the steel material.

The steel material having the iron nitride layer formed over the surface in this manner was also dip coated with a sol of 0.8% hydrated chromium oxide (III) (prepared by reducing chromic acid) followed by drying. Cr deposit as measured using a fluorescent X-ray analyzer was 25 mg/m².

The steel material having the iron nitride layer formed on which the inorganic compound layer containing chromium oxide was formed in this manner was also applied with a high frequency wave at 850°C for three seconds using the same induction quenching device of Example 1, immediately followed by water cooling for quenching.

### Example 6

An SCM 440 tempered material 8 mm in diameter and 12 mm in length was used as a substrate, whose surface was degreased, and was then nitrocarburized in a fused salt bath at 570°C for two hours (Isonite treatment: Nihon Parkerizing Co., Ltd.) to form an iron nitride layer 12 µm in thickness over the surface of the steel material.

To the steel material having the iron nitride layer formed over the surface in this manner, a coating solution containing a 3% peroxotitanic acid sol and 0.2% calcium oxalate was also dip coated and was then dried at 250°C. Deposits of Ti and Ca as measured using a fluorescent X-ray analyzer were 310 mg/m² and 40 mg/m² respectively.

The steel material having the iron nitride layer formed on which the inorganic compound layer comprising oxides containing Ti and Ca was formed in this manner was also applied with a high frequency wave at 800°C for five seconds using the same induction quenching device of Example 1, immediately followed by water cooling for quenching.

### Example 7

A tempered material (SCM 440) 20 mm in diameter and 40 mm in length was used as a substrate, whose surface was degreased, and was then treated in an ion plating device for one hour to form a hard nitride layer comprising titanium nitride 3 µm in thickness over the surface of the steel material.

To the steel material having the titanium nitride layer formed over the surface in this manner, a coating solution containing 8% ammonium zirconium carbonate (Daiichi Kigenso Kagaku Kogyo Co., Ltd.) and yttrium oxide was also brush coated and was then dried at 150°C. Deposits of Zr and Y as measured using a fluorescent X-ray analyzer were 600 mg/m² and 35 mg/m² respectively.

The steel material having the titanium nitride layer formed on which the inorganic compound layer comprising oxides containing zirconium and yttrium was formed in this manner was also applied with a high frequency wave at 800°C for five seconds using the same induction quenching device of Example 1, immediately followed by water cooling for quenching.

### Example 8

An SCM 440 tempered material 8 mm in diameter and 12 mm in length was used as a substrate, whose surface was degreased, and was then treated in an ion plating device for two hours to form a hard nitride layer comprising chromium nitride 5 µm in thickness over the surface of the steel material.

To the steel material having the chromium nitride layer formed over the surface in this manner, a neutral dispersed sol of 4% titanium oxide in water (Paltitan 5603: anatase + amorphous sol, Nihon Parkerizing Co., Ltd.) was also dip coated, removing excess liquid, and was then dried at 180°C. Ti deposit as measured using a fluorescent X-ray analyzer was 180 mg/m².

The steel material having the chromium nitride layer formed on which the inorganic compound layer containing titanium oxide was formed in this manner was also heated at a rate of 150°C/sec using an induction quenching device and applied with a high frequency wave at 850°C for three seconds, immediately followed by water cooling for quenching.

### Example 9

An SCM 440 tempered material 8 mm in diameter and 12 mm in length was used as a substrate, whose surface was degreased, and was then treated in a plasma CVD device for three hours to form a hard nitride layer comprising boron nitride 3 µm in thickness over the surface of the steel material.

To the steel material having the boron nitride layer formed over the surface in this manner, a neutral dispersed sol of 4% titanium oxide in water (Paltitan 5603: anatase + amorphous sol, Nihon Parkerizing Co., Ltd.) was also dip coated, removing excess liquid, and was then dried at 180°C. Ti deposit as measured using a fluorescent X-ray analyzer was 160 mg/m².

The steel material having the boron nitride layer formed on which the inorganic compound layer containing titanium oxide was formed in this manner was also heated at a rate of 150°C/sec using an induction quenching device and applied with a high frequency wave at 850°C for three seconds, immediately followed by water cooling for quenching.

### Example 10

A tempered material (SCM 440) 20 mm in diameter and 40 mm in length was used as a substrate, whose surface was degreased, and was then treated in an ion plating device for two hours to form a zirconium nitride layer 3 µm in thickness over the surface of the steel material.

To the steel material having the hard nitride layer formed over the surface in this manner, a sol solution of 2% tantalum hydroxide and 0.3% niobium hydroxide was also dip coated and was then dried. Tantalum deposit as measured using a fluorescent X-ray analyzer was 70 mg/m².

The steel material having the zirconium nitride layer formed on which the inorganic compound layer containing tantalum and niobium was formed in this manner was also applied with a high frequency wave at 850°C for three seconds using the same induction quenching device of Example 1, immediately followed by water cooling for quenching.

### Example 11

An SCM 440 tempered material 8 mm in diameter and 12 mm in length was used as a substrate, whose surface was degreased, and was then nitrocarburized in a fused salt bath at 570°C for two hours (Isonite treatment: Nihon Parkerizing Co., Ltd.) to form an iron nitride layer 12 µm in thickness over the surface of the steel material.

To the steel material having the iron nitride layer formed over the surface in this manner, a coating solution containing 2% hafnium oxalate was also dip coated and was dried at 250°C. Hf deposit as measured using a fluorescent X-ray analyzer was 120 mg/m².

The steel material having the iron nitride layer formed on which the inorganic compound layer comprising an oxide containing Hf was formed in this manner was also applied with a high frequency wave at 800°C for five seconds using the same induction quenching device of Example 1, immediately followed by water cooling for quenching.

### Comparative Example 1

The same carbon steel material of Example 1 was used as a substrate, whose surface was degreased, and was then nitrocarburized in a fused salt bath at 570°C for one hour (Isonite treatment: Nihon Parkerizing Co., Ltd.) to form an iron nitride layer 12 µm in thickness over the surface of the steel material and was then applied with a high frequency wave at 850°C for three seconds using the same induction quenching device of Example 1, immediately followed by water cooling for quenching.

### Comparative Example 2

The same carbon steel material of Example 1 was used as a substrate, whose surface was degreased, and was then nitrocarburized in a fused salt bath at 570°C for one hour (Isonite treatment: Nihon Parkerizing Co., Ltd.) to form an iron nitride layer about 5 µm in thickness over the surface of the steel material.

To the steel material having the iron nitride layer formed over the surface in this manner, an anticarburizing solution based on silicon oxide was also dip coated, removing excess liquid, and was then dried. Si deposit as measured using a fluorescent X-ray analyzer was 350 mg/m².

The steel material having the iron nitride layer formed on which the inorganic compound layer containing titanium oxide was formed in this manner was also applied with a high frequency wave at 850°C for three seconds using the same induction quenching device of Example 1, immediately followed by water cooling for quenching.

### Comparative Example 3

The same carbon steel material of Example 1 was used as a substrate, whose surface was degreased, and was then treated in an ion plating device for one hour to form a hard nitride layer comprising titanium oxide 3 µm in thickness over the surface of the steel material. Using the same induction quenching device of Example 1, a high frequency wave was then applied at 850°C for three seconds, immediately followed by water cooling for quenching.

### Comparative Example 4

The same carbon steel material of Example 1 was used as a substrate, whose surface was degreased, and was then treated in an ion plating device for one hour to form a hard nitride layer comprising chromium nitride 5 µm in thickness over the surface of the steel material. Using the same induction quenching device of Example 1, a high frequency wave was then applied at 850°C for three seconds, immediately followed by water cooling for quenching.

### Comparative Example 5

The same carbon steel material of Example 1 was used as a substrate, whose surface was degreased, and was then treated in a plasma CVD device for three hours to form a hard nitride layer comprising boron nitride 3 µm in thickness over the surface of the steel material. Using the same induction quenching device of Example 1, a high frequency wave was then applied at 850°C for three seconds, immediately followed by water cooling for quenching.

### Evaluation testing

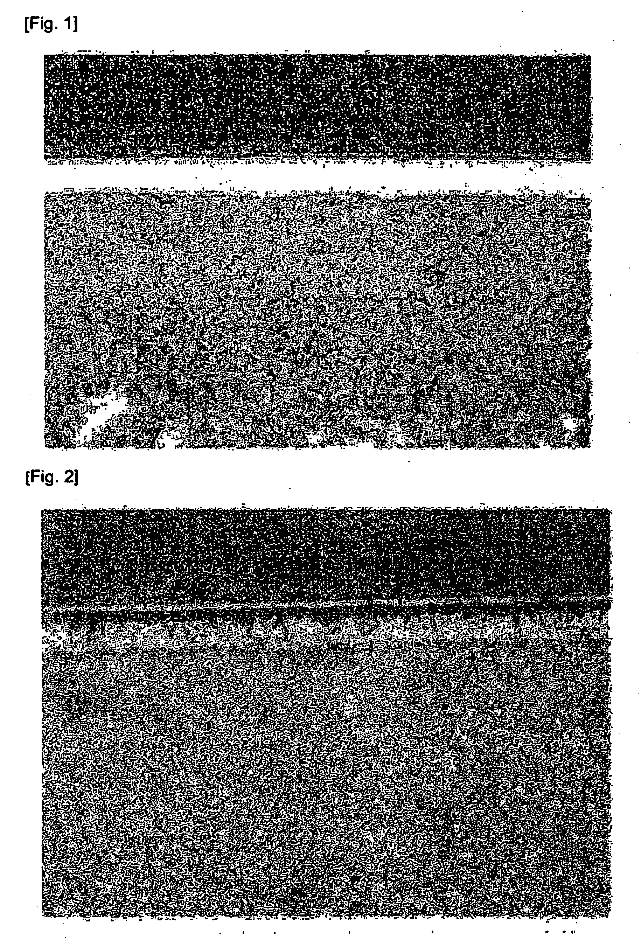

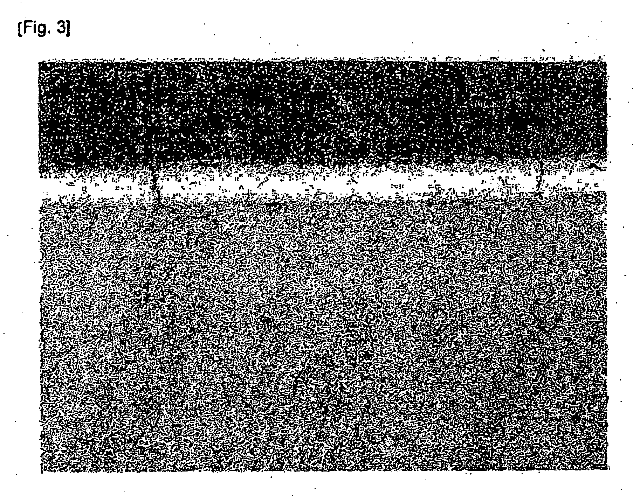

The steel materials treated as described above were cut with a microcutter to observe conditions of the remaining nitride layers through metallurgical microscopy and hardness at the cross sections of the outermost surface and 0.1 mm from the surface was measured with a Microvickers hardness scale. The results of the evaluation testing are listed in Table 1. Also, metallurgical microscopic photographs of the cross sections of Example 1 and Comparative Examples 1 and 2 are shown in Figs. 1 to 3. In each of Figs. 1 to 3, the central whiter portion is the inorganic compound layer containing iron nitride and the lower portion is the steel substrate.

**Table 1**

| No. | conditions of remaining compound layers | surface hardness [Hv] | hardness at 0.1 mm in depth [Hv] |
|---|---|---|---|
| Example 1 | unchanged | 810 | 800 |
| Example 2 | unchanged | 815 | 820 |
| Example 3 | unchanged | 805 | 780 |
| Example 4 | unchanged | 805 | 780 |
| Example 5 | unchanged | 800 | 760 |
| Example 6 | unchanged | 810 | 800 |
| Example 7 | unchanged | 810 | 800 |
| Example 8 | unchanged | 815 | 800 |
| Example 9 | unchanged | 815 | 800 |
| Example 10 | unchanged | 805 | 770 |
| Example 11 | unchanged | 820 | 810 |
| Com. Example 1 | oxidatively decomposed, cracks developed | 650 | 450 |
| Com. Example 2 | cracks developed | 780 | 380 |
| Com. Example 3 | discolored | 740 | 580 |
| Com. Example 4 | discolored | 760 | 520 |
| Com. Example 5 | discolored | 740 | 560 |

It can be seen from the table that, in Examples 1 to 11 of the present invention, the nitride layers at the surface remained undamaged after quenching with sufficiently high hardness at cross sections at the surface and down to a certain depth from the surface. In contrast, in Comparative Example 1 wherein no protective layer was coated, oxidative decomposition of the compound layer comprising iron nitride progressed, changing the nitride into an oxide to decrease the hardness at the surface. In Comparative Example 2 wherein a protective layer was formed by Si oxide, the compound layer was also damaged to lose some part of it and sufficient quenching effects were not obtained because of insufficient thermal conductivity of the SiO₂ film, with an unfavorable decrease in the cross sectional hardness observed.

The quenched steel member, the process for producing a quenched steel member and the use of the surface protective agent for use in contacting a steel material having a hard nitride layer over its surface in a process for producing a quenched steel member according to the present invention are applicable to all steel members requiring hardness, abrasion resistance and fatigue strength including parts such as gear, shafts and cams of machines, automobiles, industrial machines, machine tools or the like, as well as tools, molds and bearings. Also, corrosion resistance, adherence and/or antistatic properties can simultaneously be provided through selection of compositions of inorganic compound layers so that use may be made in other applications than those mentioned to give a wide range of industrial applications.

### BRIEF EXPLANATION OF DRAWINGS

Fig. 1 is a cross sectional photograph of a compound layer after quenching a steel material of Example 1;
Fig. 2 is a cross sectional photograph of a compound layer after quenching a steel material of Comparative Example 1; and
Fig. 3 is a cross sectional photograph of a compound layer after quenching a steel material of Comparative Example 2.

## Claims

1. A quenched steel member, wherein a hard nitride layer is formed on the surface of a steel material and, as a layer over the layer, an inorganic compound layer containing at least one metal oxide selected from the group consisting of Ti, Zr, Hf, V, Nb, Ta, Cr, W, Mo and Al within the range of 1 to 2000 mg/m² in total in terms of such metals.

2. The quenched steel member according to Claim 1, wherein the inorganic compound layer containing the metal oxide further contains at least one member selected among Ca, Mg, Y, Sc and Ba.

3. The quenched steel member according to Claim 1 or 2, wherein the hard nitride layer is at least one nitride selected among Fe, Ti, Zr, Mo, W, Cr, B and Si.

4. The quenched steel member according to any one of Claims 1 to 3, which is a machine structural part to be used in regions with a high contact pressure.

5. A process for producing a quenched steel member as defined in any preceding claim, which comprises contacting a steel material having a hard nitride layer over its surface with a ceramic precursor-containing liquid containing at least one element selected from the group consisting of Ti, Zr, Hf, V, Nb, Ta, Cr, W, Mo and Al within the range of 1 to 2000 mg/m² in total in terms of such metals in the liquid applied to the surface of the steel before quenching, before carrying out a quenching treatment.

6. The process for producing a quenched steel member according to Claim 5, wherein the ceramic precursor-containing liquid further contains at least one element selected among Ca, Mg, Y, Sc and Ba.

7. The process for producing a quenched steel member according to Claim 5 or 6, wherein the quenching treatment is induction quenching.

8. Use of a surface protective agent comprising a ceramic precursor-containing liquid containing at least one element selected from the group consisting of Ti, Zr, Hf, V, Nb, Ta, Cr, W, Mo and Al within the range of 1 to 2000 mg/m² in total in terms of such metals in the liquid applied to the surface of the steel before quenching, for contacting a steel material having a hard nitride layer over its surface in a process for producing a quenched steel member as defined in any of claims 1-4.

9. The use of Claim 8, wherein the ceramic precursor-containing liquid further contains at least one element selected among Ca, Mg, Y, Sc and Ba.

## Patentansprüche

1. Abgeschrecktes Stahlteil, worin eine harte Nitridschicht auf der Oberfläche eines Stahlmaterials sowie, als eine Schicht über der Schicht, eine Schicht einer anorganischen Verbindung gebildet ist, die mindestens ein Metalloxid ausgewählt aus der Gruppe bestehend aus Ti, Zr, Hf, V, Nb, Ta, Cr, W, Mo und Al im Bereich von insgesamt 1 bis 2.000 mg/m², in Bezug auf diese Metalle, enthält.

2. Abgeschrecktes Stahlteil gemäß Anspruch 1, worin die Schicht der anorganischen Verbindung, die das Metalloxid enthält, weiterhin mindestens ein Element ausgewählt aus Ca, Mg, Y, Sc und Ba enthält.

3. Abgeschrecktes Stahlteil gemäß Anspruch 1 oder 2, worin die harte Nitridschicht mindestens ein Nitrid ausgewählt aus Fe, Ti, Zr, Mo, W, Cr, B und Si darstellt.

4. Abgeschrecktes Stahlteil gemäß irgendeinem der Ansprüche 1 bis 3, das ein Strukturelement einer Maschine ist, das in Bereichen mit hohem Kontaktdruck einzusetzen ist.

5. Verfahren zur Herstellung eines abgeschreckten Stahlteils gemäß irgendeinem der vorhergehenden Ansprüche, das das in Kontakt bringen eines Stahlmaterials, das eine harte Nitridschicht auf seiner Oberfläche aufweist, mit einer Keramikvorläufer enthaltenden Flüssigkeit umfasst, die mindestens ein Element ausgewählt aus der Gruppe bestehend aus Ti, Zr, Hf, V, Nb, Ta, Cr, W, Mo und Al im Bereich von insgesamt 1 bis 2.000 mg/m² in Bezug auf die Metalle in der Flüssigkeit, die vor dem Abschrecken auf die Oberfläche des Stahls aufgebracht wird, enthält, vor der Durchführung einer Abschreckungsbehandlung.

6. Verfahren zur Herstellung eines abgeschreckten Stahlteils gemäß Anspruch 5, worin die Keramikvorläufer enthaltende Flüssigkeit weiterhin mindestens ein Element ausgewählt aus Ca, Mg, Y, Sc und Ba enthält.

7. Verfahren zur Herstellung eines abgeschreckten Stahlteils gemäß Anspruch 5 oder 6, worin die Abschreckbehandlung ein Induktionsabschrecken ist.

8. Verwendung eines Oberflächenschutzmittels, das eine Keramikvorläufer enthaltende Flüssigkeit umfasst, die mindestens ein Element ausgewählt aus der Gruppe bestehend aus Ti, Zr, Hf, V, Nb, Ta, Cr, W, Mo und Al im Bereich von insgesamt 1 bis 2.000 mg/m² in Bezug auf diese Metalle in der vor dem Abschrecken auf die Oberfläche des Stahls aufgebrachten Flüssigkeit enthält, zum in Kontakt bringen mit einem Stahlmaterial, das eine harte Nitridschicht auf seiner Oberfläche aufweist, in einem Verfahren zur Herstellung eines abgeschreckten Stahlteils gemäß irgendeinem der Ansprüche 1 bis 4.

9. Verwendung gemäß Anspruch 8, worin die Keramikvorläufer enthaltende Flüssigkeit weiterhin mindestens ein Element ausgewählt aus Ca, Mg, Y, Sc und Ba enthält.

## Revendications

1. Élément en acier trempé, dans lequel une couche de nitrure dure est formée sur la surface d'un matériau en acier et, en tant que couche sur la couche, une couche de composé inorganique contenant au moins un oxyde métallique choisi dans le groupe constitué de Ti, de Zr, de Hf, de V, de Nb, de Ta, de Cr, de W, de Mo et d'Al dans la plage allant de 1 à 2000 mg/m² au total en termes de ces métaux.

2. Élément en acier trempé selon la revendication 1, dans lequel la couche de composé inorganique contenant l'oxyde métallique contient en outre au moins un élément choisi parmi Ca, Mg, Y, Sc et Ba.

3. Élément en acier trempé selon la revendication 1 ou 2, dans lequel la couche de nitrure dure est au moins un nitrure choisi parmi Fe, Ti, Zr, Mo, W, Cr, B et Si.

4. Élément en acier trempé selon l'une quelconque des revendications 1 à 3, qui est une pièce structurelle de machine à utiliser dans des régions à forte pression de contact.

5. Procédé pour la production d'un élément en acier trempé tel que défini dans l'une des revendications précédentes, qui comprend la mise en contact d'un matériau en acier ayant une couche de nitrure dure sur sa surface avec un liquide contenant un précurseur de céramique contenant au moins un élément choisi dans le groupe constitué de Ti, de Zr, de Hf, de V, de Nb, de Ta, de Cr, de W, de Mo et d'Al dans la plage allant de 1 à 2000 mg/m² au total en termes de ces métaux dans le liquide appliqué à la surface de l'acier avant la trempe, avant d'effectuer un traitement de trempe.

6. Procédé pour la production d'un élément en acier trempé selon la revendication 5, dans lequel le liquide contenant un précurseur de céramique contient en outre au moins un élément choisi parmi Ca, Mg, Y, Sc et Ba.

7. Procédé pour la production d'un élément en acier trempé selon la revendication 5 ou 6, dans lequel le traitement de trempe est une trempe par induction.

8. Utilisation d'un agent de protection de surface comprenant un liquide contenant un précurseur de céramique contenant au moins un élément choisi dans le groupe constitué de Ti, de Zr, de Hf, de V, de Nb, de Ta, de Cr, de W, de Mo et d'Al dans la plage allant de 1 à 2000 mg/m² au total en termes de ces métaux dans le liquide appliqué à la surface de l'acier avant la trempe, pour une mise en contact avec un matériau en acier ayant une couche de nitrure dure sur sa surface dans un procédé de production d'un élément en acier trempé tel que défini dans l'une des revendications 1 à 4.

9. Utilisation de la revendication 8, dans lequel le liquide contenant un précurseur de céramique contient en outre au least un élément choisi parmi Ca, Mg, Y, Sc et Ba.
